# EUROPÄISCHE PATENTSCHRIFT

(11) **EP 0 244 607 B1**
(45) Veröffentlichungstag und Bekanntmachung des Hinweises auf die Patenterteilung: **09.06.1993**
(21) Anmeldenummer: 87104024.2
(22) Anmeldetag: 19.03.1987
(51) Int. Cl.: H01L 21/82, H01L 29/08

(54) **Verfahren zum Herstellen von optimierten komplementären MOS-Feldeffekttransistoren in VLSI-Technik**
Method of producing optimized CMOS field effect transistors of the VLSI technique
Méthode pour fabriquer des transistors CMOS optimisés à effet de champ en technologie VLSI

(30) Priorität: 08.04.1986 DE 3611797
(43) Veröffentlichungstag der Anmeldung: 11.11.1987
(73) Patentinhaber: SIEMENS AKTIENGESELLSCHAFT, 80333 München (DE)
(72) Erfinder: Müller, Wolfgang, Dr., D-8011 Putzbrunn (DE)

(56) Entgegenhaltungen:
- EP-A- 0 169 600
- PATENT ABSTRACTS OF JAPAN, Band 6, Nr. 238 (E-144)[1116], 26. November 1982; & JP-A-57 138 182 (NIPPON DENKI K.K.) 26-08-1982
- INTERNATIONAL ELECTRON DEVICES MEETING 1985, Washington, DC, 1.-4. Dezember 1985, Seiten 238-241, IEEE; M. NAKAHARA et al.: "Relief of hot carrier constraint on submicron CMOS devices by use of a buried channel structure"

## Beschreibung

Die Erfindung betrifft ein Verfahren zum Herstellen von komplementären MOS-Feldeffekttransistoren (CMOS-Schaltungen) in VLSI-Technik (= very large scale integration), bei dem für die Aufnahme der n- bzw. pKanal-Transistoren der Schaltung im Siliziumsubstrat pbzw. n-dotierte Wannen erzeugt werden, in welche zur Einstellung der verschiedenen Transistoreinsatzspannungen die entsprechenden Dotierstoffatome durch mehrfache Ionenimplantation eingebracht werden, wobei die Maskierung für die einzelnen Ionenimplantationen durch Fotolack- und/oder durch Siliziumoxid- bzw. Siliziumnitridstrukturen erfolgt, bei dem weiterhin zur Verminderung der Unterdiffusion der implantierten Source/Drain-Bereiche unter die Gatefläche die Gate-Elektroden mit einem Flankenoxid (spacer oxid) versehen werden und bei dem die Herstellung der Source/Drain- und Gatebereiche sowie die Erzeugung des Zwischen- und Isolationsoxids und der Kontaktmetallebenen nach bekannten Verfahrensschritten der MOS-Technologie vorgenommen wird.

Im Strukturbereich von 1 µm gewinnen bei einer Versorgungsspannung von 5 V parasitäre Effekte wie Source/Drain-Überlappungskapazitäten, der Potentialdurchgriff von Drain zu Source (Punchthrough) und die durch die hohen elektrischen Feldstärken bei Drain induzierten sogenannten "Hot-Electron"-Effekt an Bedeutung. Erstgenannter Effekt beeinträchtigt die Schaltgeschwindigkeit; der Punchthrough führt zu einer nicht ausreichenden Sperrfähigkeit des Transistors und durch den Hot-Electron-Effekt wird eine Langzeitinstabilität der Kennlinien bewirkt.

Zur Unterdrückung dieser Effekte werden MOS-Feldeffekttransistoren mit geeignet eingestelltem Profil der Source/Drain-Diffusion vorgeschlagen. Über einen sogenannten "Source/Drain-Pullback", wie in der europäischen Patentanmeldung 0 123 182 und auch in einem Bericht von K. Ohta et. al. im IEEE ED-27 (1980) auf den Seiten 1352 bis 1358 beschrieben, läßt sich die Source/Drain-Diffusion gegen die Gatekante rückversetzen, um so eine Reduktion der Überlappkapazitäten zu erhalten.

Transistoren mit einem niederdotierten Anschlußbereich zum Kanal, wie die als Lightly Doped-Drain- (LDD) bezeichneten Transistoren, die in einem Bericht von S. Ogura et. al. im IEEE ED-27 (1980), auf den Seiten 1359 bis 1367 beschrieben sind oder als Lightly Doped Drain Double Diffused (LD³) bezeichneten Transistoren, die in einem Bericht von S. Ogura et al. im IEDM 1982, Seiten 718 bis 721, beschrieben sind, oder als Buried Channel Lightly Doped Drain (BCLDD) bezeichneten Transistoren, die in einem Bericht von S. Megura et al. im IEDM 1983, Seiten 59 bis 62 beschrieben sind, führen zu verbesserten Punchthrough-Verhalten und zu einer deutlichen Verringerung der Hot-Electron-Effekte.

Ein Verfahren der eingangs genannten Art ist beispielsweise aus der europäischen Patentanmeldung 0 123 182 bekannt. Bei diesem Verfahren wird die Unterdiffusion der MOS-Transistorgates durch ein Zurückziehen (Pullback) von der Gatekante dadurch zu verhindern versucht, daß vor der Source/Drain-Implantation ein Spacer Oxid durch Reoxidation des Polysilizium-Gates gebildet wird.

Aus der EP-A-0 169 600 ist ein Verfahren bekannt, bei dem die Spacer-Oxid-Breiten für n-Kanal- und p-Kanal-Transistoren durch ein bestimmtes Maskierungsverfahren mit Hilfe von durch anisotropes Ätzen erzeugten Spacers unabhängig voneinander eingestellt werden können.

Die Aufgabe, die der Erfindung zugrundeliegt, besteht in der Durchführung einer 1 µm-Prozeßfolge zur Herstellung von optimierten CMOS-Transistoren, bei der n-Kanal- und p-Kanal-Transistoren weitgehend entkoppelt ohne einen Mehraufwand an Maskenschritten und ohne die obengenannten Effekte (Überlappkapazitäten, Punchthrough, Hot-Electrons) realisiert werden können.

Diese Aufgabe wird durch ein Verfahren der eingangs genannten Art gelöst, welches durch den Ablauf folgender Verfahrensschritte gekennzeichnet ist:
a) Abscheidung einer ersten SiO₂-Schicht in einer Schichtdicke, die der Flankenoxidbreite des Gates des später zu erzeugenden p-Kanal-Transistors entspricht, auf ein p- bzw. n-dotiertes Siliziumsubstrat, in welchem nach bekannten Verfahrensschritten die n- bzw. p-Wannen, aktive Transistorbereiche trennende Feldoxidbereiche sowie die Kanalimplantationen für die n-Kanal- und p-Kanal-Transistoren und auf welchen ein Gateoxid und die Gate-Elektroden für die n- bzw. p-Kanal-Transistoren bereits definiert sind,
b) Abscheidung einer Siliziumnitridschicht auf der ersten SiO₂-Schicht,
c) Durchführung einer Photolacktechnik und Strukturierung der aus der SiO₂-Schicht und der Siliziumnitridschicht bestehenden Doppelschicht so, daß der spätere p-Kanalbereich mit der Doppelschicht bedeckt bleibt,
d) Durchführung einer thermischen Oxidation der Gate-Elektroden der n-Kanal-Transistoren nach Entfernen der Photolackmaske,
e) Durchführung einer Anschlußimplantation für den n-Kanal-Transistor,
f) Abscheidung einer zweiten SiO₂-Schicht und anisotrope Rückätzung dieser Schicht so, daß an den Flanken der n-Kanal-Transistor-Gate-Elektroden Oxidbereiche stehenbleiben,
g) Durchführung der Source/Drain-Ionenimplantation zur Erzeugung der n-Kanal-Transistoren und Eintreiben der implantierten Dotierstoffe,
h) Aufbringen einer Photolackmaske auf den nicht mit der Doppelschicht bedeckten n-Kanalbereich und Entfernung der restlichen zweiten SiO₂-Schicht an den durch die Doppelschicht erzeugten Stufen im p-Kanalbereich durch isotropes Überätzen,
i) Entfernen der Siliziumnitridschicht,
j) anisotropes Rückätzen der ersten SiO₂-Schicht so, daß an den Flanken der Gate-Elektroden im p-Kanalbereich Oxidbereiche und auf dem aktiven p-Kanal-Transistorbereich ein Restoxid mit einer Schichtdicke von ca. 50 nm oder kleiner stehenbleiben,
k) Durchführung der Source/Drain-Ionenimplantation zur Erzeugung der p-Kanal-Transistoren und Entfernung der Photolackmaske und
l) Erzeugung des Zwischenisolationsoxids, der Kontaktlochbereiche und der Metallisierung in bekannter Weise.

Weitere Ausgestaltungen der Erfindung ergeben sich aus den Unteransprüchen.

Durch das Verfahren nach der Lehre der Erfindung können Spacer-Oxid-Breiten für n-Kanal- und p-Kanal-Transistoren unabhängig voneinander gewählt werden und damit beide Transistoren unabhängig optimiert werden. Es sind drei Varianten für n-Kanal- und p-Kanal-Transistoren möglich:
1. Lightly Doped Drain- n-Kanal-Transistor und p-Kanal Transistor mit rückversetztem Source/Drain (= Source/Drain-Pullback).
2. Lightly Doped Drain-n-Kanal-Transistor und Buried-Channel Lightly Doped Drain-p-Kanal-Transistor und
3. Lightly Doped Drain doppelt implantierter n-Kanal-Transistor und Lightly Doped Drain-p-Kanal-Transistor.

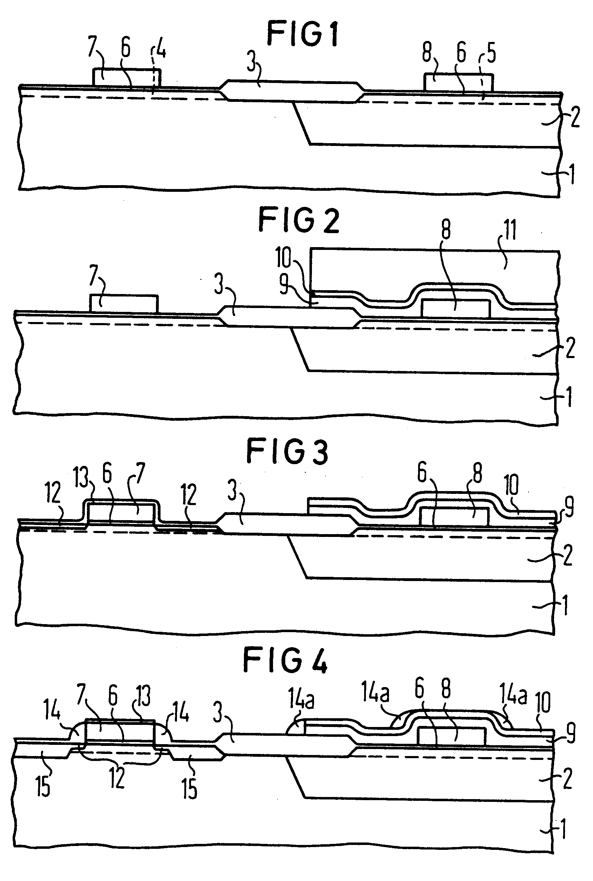

Im folgenden wird anhand der Figuren 1 bis 6 die Variante 2 näher beschrieben. Dabei zeigen die Figuren im Schnittbild die erfindungswesentlichen Verfahrensschritte, wobei in allen Figuren gleiche Teile mit gleichen Bezugszeichen versehen sind. Das Ausführungsbeispiel betrifft einen n-Wannen-CMOS-Prozeß (für den p-Wannen-Prozeß sind die Überlegungen identisch).

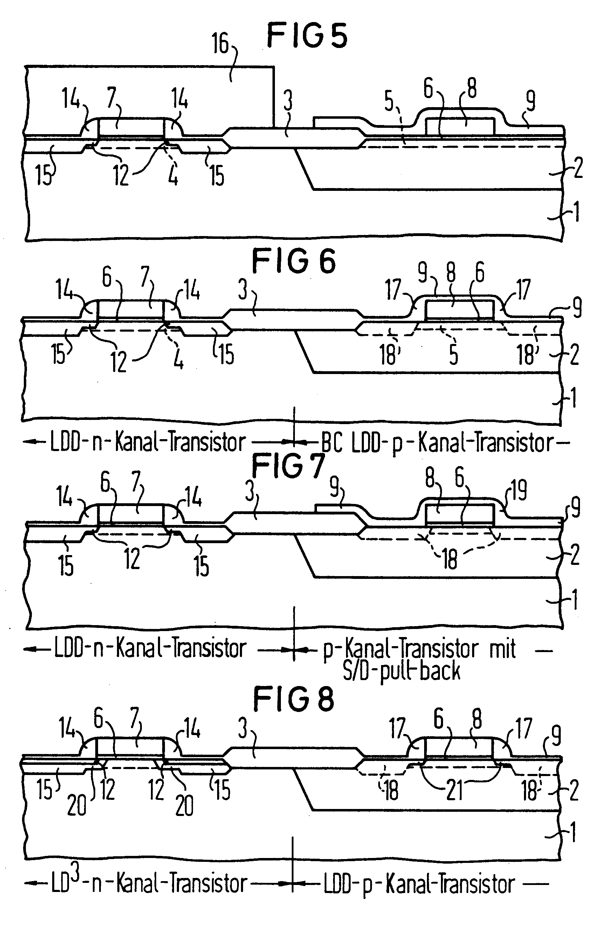

Die Realisierung der Variante 1 (Figur 7) und der Variante 3 (Figur 8) ergibt sich geringfügige Abänderung der in den Figuren 1 bis 6 beschriebenen Verfahrensschritte. Im Anschluß an die Figurenbeschreibung wird darauf näher eingegangen.

Figur 1: In einem herkömmlichen CMOS-Prozeß werden Wannenbereiche und aktive Bereiche definiert. Das Gateoxid der Transistoren wird gewachsen, die Kanalimplantation der n-Kanal- und p-Kanal-Transistoren eingebracht und die Gateelektroden, zum Beispiel aus Polysilizium oder Polyzid bestehend, abgeschieden und strukturiert. Den Querschnitt durch einen n-Kanal- und p-Kanal-Transistor zu diesem Zeitpunkt zeigt die Figur 1. Dabei ist mit dem Bezugszeichen 1 das p-dotierte Siliziumsubstrat, mit 2 die n-Wanne für den p-Kanal-Transistor, mit 3 das die aktiven Transistorbereiche trennende Feldoxid, mit 4 und 5 die Kanalimplantation, mit 6 das Gateoxid und mit 7 und 8 die strukturierten Gateelektroden bezeichnet.

Figur 2: Nun wird ganzflächig durch Abscheidung aus der Gasphase (CVD) zunächst eine 100 - 200 nm dicke erste SiO₂Schicht 9 aufgebracht und darauf eine CVD-Siliziumnitridschicht 10 in einer Schichtdicke von 50 nm abgeschieden. Dabei ist die Schichtdicke der ersten SiO₂-Schicht 9 der Flankenoxidbreite der Gates des später zu erzeugenden p-Kanal-Transistors angepaßt; die Siliziumnitridschicht 10 dient als Schutzschicht für den anisotropen Rückätzschritt zur Erzeugung der Oxidspacer 14 der n-Kanal-Transistoren. In einem nachfolgenden Photolithographieschritt werden die späteren p-Kanalbereiche (Wanne 2) mit einer ersten Photolackmaske 11 abgedeckt und die aus SiO₂/Siliziumnitrid bestehende Doppelschicht 9, 10 strukturiert. Es entsteht die in Figur 2 dargestellte Anordnung.

Figur 3: Die Photolackmaske 11 wird entfernt und eine thermische Oxidation bis zum Aufwachsen einer Oxidschichtdicke 13 von 30 bis 50 nm durchgeführt. Dann erfolgt die Anschlußimplantation für den n-Kanal-Transistor (LDD) mit Phosphor-Ionen mit einer Dosis und Energie von 5 × 10¹² bis 1 × 10¹³ cm⁻² und 80 keV. Es entsteht die implantierte Zone 12.

Figur 4: Nach dem Abscheiden einer zweiten SiO₂-Schicht (14, CVD) in einer Schichtdicke von 0,2 µm werden aus dieser Schicht durch anisotropes Rückätzen der über die Gatestufen konform abgeschiedenen CVD SiO₂-Schicht (14) an den Flanken der n-Kanal-Gate-Elektrode 7 die sogenannten Spacer Oxide 14 gebildet. Reste dieser Oxidschicht befinden sich als Schichtteile 14a an den Stufen der p-KanalGate-Elektrode 8 und über dem Feldoxid im Bereich der p-Kanal-Transistoren. Anstelle einer zweiten SiO₂-Schicht (14) zur Spacerbildung kann auch eine undotierte Polysiliziumschicht abgeschieden werden. In diesem Falle ist die Siliziumnitridschicht 10 (siehe Figur 2) nicht erforderlich. Nun werden die Source/Drain-Bereiche 15 der n-Kanal-Transistoren durch Arsen-Ionenimplantation bei einer Dosis und Energie von 3 × 10¹⁵ bis 8 × 10¹⁵ cm⁻² und 80 keV gebildet. Bei Verwendung einer SiO₂Schicht (14) zur Spacerbildung muß vor der Arsenimplantation noch ein Streuoxid (30 bis 50 nm Schichtdicke, nicht abgebildet) aufgewachsen werden. Abschließend erfolgt die thermische Aktivierung der n⁺-Diffusion zur Einstellung des gewünschten Schichtwiderstandes. Es entsteht die in Figur 4 dargestellte Struktur.

Figur 5: Mit Hilfe einer zweiten Photolackmaske 16 werden nun die n-Kanal-Bereiche abgedeckt und eine isotrope Überätzung zur Entfernung der Oxidreste 14a an den Stufen im p-Kanalbereich durchgeführt. Nach Entfernung der Siliziumnitridschicht 10 entsteht die in Figur 5 dargestellte Anordnung.

Figur 6: Durch anisotropes Rückätzen der ersten SiO₂-Schicht 9 werden nun an den Flanken der Gate-Elektrode 8 im p-Kanal-Bereich die Spacer Oxide 17 definiert. Dabei wird die Ätzung so geführt, daß noch ein Restoxid 9 in einer Schichtdicke von etwa 50 nm auf den aktiven Transistorbereichen verbleibt. Die Source/Drain-Bereiche 18 der p-Kanal-Transistoren werden durch Bor-Ionenimplantation mit einer Energie und Dosis von 5 × 10¹⁵ cm⁻² bei 25 keV gebildet. Nach Entfernung der Lackmaske 16 entsteht die in Figur 6 dargestellte Struktur, aus der auch die Bereiche für den LDD-n-Kanal-Transistor und den BC LDD-p-Kanal-Transistor ersichtlich sind. Die weitere Prozeßfolge wie Zwischenoxidabscheidung und Verfließen, Kontaktlochdefinition und Metallisierung folgt dem herkömmlichen Prozeß und ist hier nicht dargestellt.

Figur 7: Die Variante 1 LDD-n-Kanal-Transistor und p-Kanal-Transistor mit rückversetztem Source/Drain folgt direkt aus der in den Figuren 1 bis 6 angegebenen Prozeßfolge. Der in Figur 6 angegebene Rückätzschritt entfällt. In diesem Fall liegt vor der Source/Drain-Implantation 18 für die p-Kanal-Transistoren ein sogenannter konformer Spacer 19 vor. Die Dicke der ersten SiO₂-Schicht 9, die Implantationsenergie (18) und die nachfolgenden Hochtemperaturprozesse sind entsprechend so zu wählen, daß die Source/Drain-Dotierung (18) knapp unter die Gateelektrode (8) reicht.

Figur 8: Die Variante 3 LD³-n-Kanal-Transistor und LDD-p-Kanal-Transistor folgt aus der in den Figuren 1 bis 6 angegebenen Prozeßfolge, wenn unmittelbar vor dem Abscheiden der ersten SiO₂-Schicht 9 (Schritt a) eine ganzflächige Borimplantation von etwa 10¹² cm⁻² bei 25 bis 50 keV eingebracht wird. Diese Bor-Ionenimplantation fungiert als Bor-"pocket"-Implantation 20 für den n-Kanal-Transistor (siehe Bericht von S. Ogura et. al. im IEDM 1982, Seiten 718 bis 721) und als Anschlußimplantation 21 des LDD-p-Kanal-Transistors.

## Patentansprüche

1. Verfahren zum Herstellen von komplementären MOS-Feldeffekttransistoren in VLSI-Technik, bei dem für die Aufnahme eines n- bzw. p-Kanal-Transistors der Schaltung im Siliziumsubstrat p- bzw. n-dotierte Wannen erzeugt werden, in welche zur Einstellung der verschiedenen Transistoreinsatzspannungen die entsprechenden Dotierstoffatome durch mehrfache Ionenimplantation eingebracht werden, wobei die Maskierung für die einzelnen Ionenimplantationen durch Fotolack- und/oder durch Siliziumoxid- bzw. Siliziumnitridstrukturen erfolgt, bei dem weiterhin zur Verminderung der Unterdiffusion implantierter Source/Drain-Bereiche unter die Gatefläche Gate-Elektroden mit einem Flankenoxid versehen werden, und bei dem die Herstellung der Source/Drain- und Gatebereiche sowie die Erzeugung eines Zwischen- und Isolationsoxids und von Kontaktmetallebenen nach bekannten Verfahrensschritten der MOS-Technologie vorgenommen wird, **gekennzeichnet durch** den Ablauf folgender Verfahrensschritte:
a) Abscheidung einer ersten SiO₂-Schicht (9) in einer Schichtdicke, die der Flankenoxidbreite (17, 19) des Gates (8) des später zu erzeugenden p-Kanal-Transistors entspricht, auf ein p- bzw. n-dotiertes Siliziumsubstrat (1), in welchem nach bekannten Verfahrensschritten die n- bzw. p-Wannen (2), aktive Transistorbereiche trennende Feldoxidbereiche (3) sowie Kanalimplantationen (4, 5) für den n-Kanal- und p-Kanal-Transistor und auf welchen ein Gateoxid (6) und die Gate-Elektroden (7, 8) für den n- bzw. p-Kanal-Transistor bereits definiert sind,
b) Abscheidung einer Siliziumnitridschicht (10) auf der ersten SiO₂-Schicht (9),
c) Durchführung einer Photolacktechnik (11) und Strukturierung der aus der SiO₂-Schicht (9) und der Siliziumnitridschicht (10) bestehenden Doppelschicht so, daß der spätere p-Kanalbereich (2) mit der Doppelschicht bedeckt bleibt,
d) Durchführung einer thermischen Oxidation (13) der Gate-Elektrode (7) des n-Kanal-Transistors nach Entfernen der Photolackmaske (11),
e) Durchführung einer Anschlußimplantation (12) für den n-Kanal-Transistor,
f) Abscheidung einer zweiten SiO₂-Schicht (14) und anisotrope Rückätzung dieser Schicht so, daß an den Flanken der n-Kanal-Transistor-Gate-Elektrode (7) Oxidbereiche (14) stehenbleiben,
g) Durchführung der Source/Drain-Ionenimplantation (15) zur Erzeugung des n-Kanal-Transistors und Eintreiben der implantierten Dotierstoffe,
h) Aufbringen einer Photolackmaske (16) auf den nicht mit der Doppelschicht bedeckten n-Kanalbereich und Entfernung der restlichen zweiten SiO₂-Schicht (14a) an durch die Doppelschicht erzeugten Stufen im p-Kanalbereich durch isotropes Überätzen,
i) Entfernen der Siliziumnitridschicht (10),
j) anisotropes Rückätzen der ersten SiO₂-Schicht (9) so, daß an den Flanken der Gate-Elektrode (8) im p-Kanalbereich (2) Oxidbereiche (17) und auf dem aktiven p-Kanal-Transistorbereich ein Restoxid mit einer Schichtdicke von ca. 50 nm oder Kleiner stehenbleiben,
k) Durchführung der Source/Drain-Ionenimplantation (18) zur Erzeugung des p-Kanal-Transistors und Entfernung der Photolackmaske (16), und
l) Erzeugung des Zwischenisolationsoxids, der Kontaktlochbereiche und der Metallisierung in bekannter Weise.

2. Verfahren nach Anspruch 1, **dadurch gekennzeichnet,** daß die erste SiO₂-Schicht (9) nach Verfahrensschritt a) durch Abscheidung aus der Gasphase (CVD = chemical vapor deposition) hergestellt wird und ihre Schichtdicke auf größer 100 nm eingestellt wird.

3. Verfahren nach Anspruch 1 und/oder 2, **dadurch gekennzeichnet,** daß die Siliziumnitridschicht (10) nach Verfahrensschritt b) durch Abscheidung aus der Gasphase (CVD) hergestellt wird und ihre Schichtdicke im Bereich von 50 bis 100 nm eingestellt wird.

4. Verfahren nach einem der Ansprüche 1 bis 3, **dadurch gekennzeichnet,** daß die zweite SiO₂-Schicht (14) nach Verfahrensschritt f) durch Abscheidung aus der Gasphase (CVD) hergestellt wird und ihre Schichtdicke auf 150 bis 300 nm eingestellt wird.

5. Verfahren nach einem der Ansprüche 1 bis 4, **dadurch gekennzeichnet,** daß die thermische Oxidation nach Verfahrensschritt d) so geführt wird, daß eine 30 bis 50 nm dicke SiO₂-Schicht (13) entsteht.

6. Verfahren nach einem der Ansprüche 1 bis 5, **dadurch gekennzeichnet,** daß die Anschlußimplantation (12) für den n-Kanal-Transistor nach Verfahrensschritt e) mit Phosphor-Ionen und einer Dosis und Energie von 5 x 10¹² bis 1 x 10¹³ cm⁻² und 80 keV durchgeführt wird.

7. Verfahren nach einem der Ansprüche 1 bis 6, **dadurch gekennzeichnet,** daß die Source/Drain-Implantation (15) des n-Kanal-Transistors nach Verfahrensschritt g) mit Arsen-Ionen und einer Dosis und Energie von 3 x 10¹⁵ bis 8 x 10¹⁵ cm⁻² und 80 keV durchgeführt wird.

8. Verfahren nach Anspruch 7, **dadurch gekennzeichnet,** daß vor der Implantation (15) ein Streuoxid in einer Schichtdicke im Bereich von 30 bis 50 nm aufgebracht wird.

9. Verfahren nach einem der Ansprüche 1 bis 8, **dadurch gekennzeichnet,** daß die Restoxiddicke nach Verfahrensschritt j) auf ca. 50 nm eingestellt wird.

10. Verfahren nach einem der Ansprüche 1 bis 9, **dadurch gekennzeichnet,** daß die Source/Drain-Implantation (18) des p-Kanal-Transistors mit Bor-Ionen bei einer Dosis und Energie von 5 x 10¹⁵ cm⁻² und 25 keV durchgeführt wird.

11. Verfahren zum Herstellen von komplementären MOS-Feldeffekttransistoren in VLSI-Technik, bei dem für die Aufnahme eines n- bzw. p-Kanal-Transistors der Schaltung im Siliziumsubstrat p- bzw. n-dotierte Wannen erzeugt werden, in welche zur Einstellung der verschiedenen Transistoreinsatzspannungen die entsprechenden Dotierstoffatome durch mehrfache Ionenimplantation eingebracht werden, wobei die Maskierung für die einzelnen Ionenimplantationen durch Fotolack- und/oder durch Siliziumoxid- bzw. Siliziumnitridstrukturen erfolgt, bei dem weiterhin zur Verminderung der Unterdiffusion implantierter Source/Drain-Bereiche unter die Gatefläche Gate-Elektroden mit einem Flankenoxid versehen werden, und bei dem die Herstellung der Source/Drain- und Gatebereiche sowie die Erzeugung eines Zwischen- und Isolationsoxids und von Kontaktmetallebenen nach bekannten Verfahrensschritten der MOS-Technologie vorgenommen wird, **gekennzeichnet durch** den Ablauf folgender Verfahrensschritte:
a) Abscheidung einer ersten SiO₂-Schicht (9) in einer Schichtdicke, die der Flankenoxidbreite (17, 19) des Gates (8) des später zu erzeugenden p-Kanal-Transistors entspricht, auf ein p- bzw. n-dotiertes Siliziumsubstrat (1), in welchem nach bekannten Verfahrensschritten die n- bzw. p-Wannen (2), aktive Transistorbereiche trennende Feldoxidbereiche (3) sowie Kanalimplantationen (4, 5) für den n-Kanal- und p-Kanal-Transistor und auf welchen ein Gateoxid (6) und die Gate-Elektroden (7, 8) für den n- bzw. p-Kanal-Transistor bereits definiert sind,
b) Durchführung einer Photolacktechnik (11) und Strukturierung der SiO₂-Schicht (9) so, daß der spätere p-Kanalbereich (2) mit der SiO₂-Schicht (9) bedeckt bleibt,
c) Durchführung einer thermischen Oxidation (13) der Gate-Elektrode (7) des n-Kanal-Transistors nach Entfernen der Photolackmaske (11),
d) Durchführung einer Anschlußimplantation (12) für den n-Kanal-Transistor,
e) Abscheidung einer undotierten Polysiliziumschicht mit einer Dicke von 0,2 bis 0,4 µm,
f) Durchführung der Source/Drain-Ionenimplantation (15) zur Erzeugung des n-Kanal-Transistors und Eintreiben der implantierten Dotierstoffe,
g) Aufbringen einer Photolackmaske (16) auf den nicht mit der SiO₂-Schicht (9) bedeckten n-Kanalbereich,
h) anisotropes Rückätzen der ersten SiO₂-Schicht (9) so, daß an den Flanken der Gate-Elektrode (8) im p-Kanalbereich (2) Oxidbereiche (17) und auf dem aktiven p-Kanal-Transistorbereich ein Restoxid mit einer Schichtdicke von ca. 50 nm oder kleiner stehenbleiben,
i) Durchführung der Source/Drain-Ionenimplantation (18) zur Erzeugung des p-Kanal-Transistors und Entfernung der Photolackmaske (16), und
j) Erzeugung des Zwischenisolationsoxids, der Kontaktlochbereiche und der Metallisierung in bekannter Weise.

12. Verfahren nach einem der Ansprüche 1 bis 11, **dadurch gekennzeichnet,** daß vor dem Aufbringen der ersten SiO₂-Schicht (9) nach Verfahrensschritt a) eine ganzflächige Bor-Ionen-Implantation (20, 21) bei einer Dosis und Energie von 10¹² cm⁻² und 25 bis 50 keV durchgeführt wird.

13. Verfahren zum Herstellen von komplementären MOS-Feldeffekttransistoren in VLSI-Technik, bei dem für die Aufnahme eines n- bzw. p-Kanal-Transistors der Schaltung im Siliziumsubstrat p- bzw. n-dotierte Wannen erzeugt werden, in welche zur Einstellung der verschiedenen Transistoreinsatzspannungen die entsprechenden Dotierstoffatome durch mehrfache Ionenimplantation eingebracht werden, wobei die Maskierung für die einzelnen Ionenimplantationen durch Fotolack- und/oder durch Siliziumoxid- bzw. Siliziumnitridstrukturen erfolgt, bei dem weiterhin zur Verminderung der Unterdiffusion implantierter Source/Drain-Bereiche unter die Gatefläche Gate-Elektroden mit einem Flankenoxid versehen werden, und bei dem die Herstellung der Source/Drain- und Gatebereiche sowie die Erzeugung eines Zwischen- und Isolationsoxids und von Kontaktmetallebenen nach bekannten Verfahrensschritten der MOS-Technologie Vorgenommen wird, **gekennzeichnet durch** den Ablauf folgender Verfahrensschritte:
a) Abscheidung einer ersten SiO₂-Schicht (9) in einer Schichtdicke, die der Flankenoxidbreite (17, 19) des Gates (8) des später zu erzeugenden p-Kanal-Transistors entspricht, auf ein p- bzw. n-dotiertes Siliziumsubstrat (1), in welchem nach bekannten Verfahrensschritten die n- bzw. p-Wannen (2), aktive Transistorbereiche trennende Feldoxidbereiche (3) sowie Kanalimplantationen (4, 5) für den n-Kanal- und p-Kanal-Transistor und auf welchen ein Gateoxid (6) und die Gate-Elektroden (7, 8) für den n- bzw. p-Kanal-Transistor bereits definiert sind,
b) Abscheidung einer Siliziumnitridschicht (10) auf der ersten SiO₂-Schicht (9),
c) Durchführung einer Photolacktechnik (11) und Strukturierung der aus der SiO₂-Schicht (9) und der Siliziumnitridschicht (10) bestehenden Doppelschicht so, daß der spätere p-Kanalbereich (2) mit der Doppelschicht bedeckt bleibt,
d) Durchführung einer thermischen Oxidation (13) der Gate-Elektrode (7) des n-Kanal-Transistors nach Entfernen der Photolackmaske (11),
e) Durchführung einer Anschlußimplantation (12) für den n-Kanal-Transistor,
f) Abscheidung einer zweiten SiO₂-Schicht (14) und anisotrope Rückätzung dieser Schicht so, daß an den Flanken der n-Kanal-Transistor-Gate-Elektrode (7) Oxidbereiche (14) stehenbleiben,
g) Durchführung der Source/Drain-Ionenimplantation (15) zur Erzeugung des n-Kanal-Transistors und Eintreiben der implantierten Dotierstoffe,
h) Aufbringen einer Photolackmaske (16) auf den nicht mit der Doppelschicht bedeckten n-Kanalbereich und Entfernung der restlichen zweiten SiO₂-Schicht (14a) an den durch die Doppelschicht erzeugten Stufen im p-Kanalbereich durch isotropes Überätzen,
i) Entfernen der Siliziumnitridschicht, (10)
j) Durchführung der Source/Drain-Ionenimplantation (18) zur Erzeugung des p-Kanal-Transistors und Entfernung der Photolackmaske (16), und
k) Erzeugung des Zwischenisolationsoxids, der Kontaktlochbereiche und der Metallisierung in bekannter Weise,
l) wobei die Dicke der ersten SiO₂-Schicht (9), die Implantationsenergie der Source/Drain-Implantation (18) nach Verfahrensschritt j) und nachfolgende Hochtemperaturprozesse so eingestellt werden, daß die Source/Drain-Dotierung (18) gerade unter die Gate-Elektrode des p-Kanal-Transistors reicht.

## Claims

1. Method for producing complementary MOS field-effect transistors using VLSI technology, in which p- or n-doped trenches are produced in the silicon substrate for holding an n- or p-channel transistor of the circuit, into which trenches the corresponding doping material atoms are incorporated by multiple ion implantation in order to set the various transistor threshold voltages, the masking for the individual ion implantations taking place by means of photoresist structures and/or by means of silicon-oxide or silicon-nitride structures, in which, furthermore, in order to prevent implanted source/drain regions diffusing under the gate area, gate electrodes are provided with an edge oxide, and in which the production of the source/drain and gate regions as well as the production of an intermediate and insulation oxide and of contact-metal planes is carried out in accordance with known method steps for MOS technology, characterised by the sequence of the following method steps:
a) deposition of a first SiO₂ layer (9) in a layer thickness which corresponds to the edge oxide width (17, 19) of the gate (8) of the p-channel transistor, which is to be produced later, onto a p-doped or n-doped silicon substrate (1) in which, using known method steps, the n-trenches or p-trenches (2), field-oxide regions (3) separating the active transistor regions and channel implantations (4, 5) for the n-channel and p-channel transistor, and on which a gate oxide (6) and the gate electrodes (7, 8) for the n-channel or p-channel transistor are already defined,
b) deposition of a silicon-nitride layer (10) on the first SiO₂ layer (9),
c) carrying out a photoresist technique (11) and the structuring of the double layer, which comprises the SiO₂ layer (9) and the silicon-nitride layer (10), such that the later p-channel region (2) remains covered by the double layer,
d) carrying out a thermal oxidation (13) of the gate electrode (7) of the n-channel transistor after removal of the photoresist mask (11),
e) carrying out a connection implantation (12) for the n-channel transistor,
f) deposition of a second SiO₂ layer (14) and anisotropic back-etching of this layer such that oxide regions (14) remain on the edges of the n-channel transistor gate electrode (7),
g) carrying out the source/drain ion implantation (15) for producing the n-channel transistor and driving in the implanted doping materials,
h) applying a photoresist mask (16) onto the n-channel region which is not covered by the double layer, and removing the remaining second SiO₂ layer (14a) by isotropic etching over at stages in the p-channel region which are produced by the double layer,
i) removal of the silicon-nitride layer (10),
j) anisotropic back-etching of the first SiO₂ layer (9) such that oxide regions (17) remain on the edges of the gate electrode (8) in the p-channel region (2), and a residual oxide having a layer thickness of approximately 50 nm or less remains on the active p-channel transistor region,
k) carrying out the source/drain ion implantation (18) in order to produce the p-channel transistor, and removal of the photoresist mask (16), and
l) production of the intermediate-insulation oxide, of the contact hole regions and of the metallisation in a known manner.

2. Method according to Claim 1, characterised in that the first SiO₂ layer (9) according to method step a) is produced by deposition from the gas phase (CVD = chemical vapour deposition), and its layer thickness is set to more than 100 nm.

3. Method according to Claim 1 and/or 2, characterised in that the silicon-nitride layer (10) according to method step b) is produced by deposition from the gas phase (CVD) and its layer thickness is set in the region from 50 to 100 nm.

4. Method according to one of Claims 1 to 3, characterised in that the second SiO₂ layer (14) according to method step f) is produced by deposition from the gas phase (CVD), and its layer thickness is set to 150 to 300 nm.

5. Method according to one of Claims 1 to 4, characterised in that the thermal oxidation according to method step d) is conducted such that an SiO₂ layer (13) is produced which is 30 to 50 nm thick.

6. Method according to one of Claims 1 to 5, characterised in that the connection implantation (12) for the n-channel transistor according to method step e) is carried out using phosphorus ions and a dose and energy of 5 × 10¹² to 1 × 10¹³ cm⁻² and 80 keV.

7. Method according to one of Claims 1 to 6, characterised in that the source/drain implantation (15) of the n-channel transistor according to method step g) is carried out using arsenic ions and a dose and energy of 3 × 10¹⁵ to 8 × 10¹⁵ cm⁻² and 80 keV.

8. Method according to Claim 7, characterised in that a scatter oxide is applied in a layer thickness in the region of 30 to 50 nm, before the implantation (15).

9. Method according to one of Claims 1 to 8, characterised in that the residual oxide thickness according to method step j) is set to approximately 50 nm.

10. Method according to one of Claims 1 to 9, characterised in that the source/drain implantation (18) of the p-channel transistor is carried out using boron ions with a dose and energy of 5 × 10¹⁵ cm⁻² and 25 keV.

11. Method for producing complementary MOS field-effect transistors using VLSI technology, in which p- or n-doped trenches are produced in the silicon substrate for holding an n- or p-channel transistor of the circuit, into which trenches the corresponding doping material atoms are incorporated by multiple ion implantation in order to set the various transistor threshold voltages, the masking for the individual ion implantations taking place by means of photoresist structures and/or by means of silicon-oxide or silicon-nitride structures, in which, furthermore, in order to prevent implanted source/drain regions diffusing under the gate area, gate electrodes are provided with an edge oxide, and in which the production of the source/drain and gate regions as well as the production of an intermediate and insulation oxide and of contact-metal planes is carried out in accordance with known method steps for MOS technology, characterised by the sequence of the following method steps:
a) deposition of a first SiO₂ layer (9) in a layer thickness which corresponds to the edge oxide width (17, 19) of the gate (8) of the p-channel transistor, which is to he produced later, onto a p-doped or n-doped silicon substrate (1) in which, using known method steps, the n-trenches or p-trenches (2), field-oxide regions (3) separating the active transistor regions and channel implantations (4, 5) for the n-channel and p-channel transistor, and on which a gate oxide (6) and the gate electrodes (7, 8) for the n-channel or p-channel transistor are already defined,
b) carrying out a photoresist technique (11) and structuring the SiO₂ layer (9) such that the later p-channel region (2) is covered by the SiO₂ layer (9),
c) carrying out a thermal oxidation (13) of the gate electrode (7) of the n-channel transistor after removing the photoresist mask (11),
d) carrying out a connection implantation (12) for the n-channel transistor
e) deposition of an undoped polysilicon layer having a thickness of 0.2 to 0.4 µm,
f) carrying out the source/drain ion implantation (15) for producing the n-channel transistor and driving in the implanted doping material,
g) applying a photoresist mask (16) onto the n-channel region which is not covered by the SiO₂ layer (9),
h) anisotropic back-etching of the first SiO₂ layer (9) such that oxide regions (17) remain on the edges of the gate electrode (8) in the p-channel region (2), and a residual oxide having a layer thickness of approximately 50 nm or less remains on the active p-channel transistor region,
i) carrying out the source/drain ion implantation (18) in order to produce the p-channel transistor, and removal of the photoresist mask (16), and
j) production of the intermediate-insulation oxide, of the contact hole regions and of the metallisation in a known manner.

12. Method according to one of Claims 1 to 11, characterised in that a complete-area boron-ion implantation (20, 21) is carried out with a dose and energy of 10¹² cm⁻² and 25 to 50 keV before the application of the first SiO₂ layer (9) according to method step a).

13. Method for producing complementary MOS field-effect transistors using VLSI technology, in which p- or n-doped trenches are produced in the silicon substrate for holding an n- or p-channel transistor of the circuit, into which trenches the corresponding doping material atoms are incorporated by multiple ion implantation in order to set the various transistor threshold voltages, the masking for the individual ion implantations taking place by means of photoresist structures and/or by means of silicon-oxide or silicon-nitride structures, in which, furthermore, in order to prevent implanted source/drain regions diffusing under the gate area, gate electrodes are provided with an edge oxide, and in which the production of the source/drain and gate regions as well as the production of an intermediate and insulation oxide and of contact-metal planes is carried out in accordance with known method steps for MOS technology, characterised by the sequence of the following method steps:
a) deposition of a first SiO₂ layer (9) in a layer thickness which corresponds to the edge oxide width (17, 19) of the gate (8) of the p-channel transistor, which is to be produced later, onto a p-doped or n-doped silicon substrate (1) in which, using known method steps, the n-trenches or p-trenches (2), field-oxide regions (3) separating the active transistor regions and channel implantations (4, 5) for the n-channel and p-channel transistor, and on which a gate oxide (6) and the gate electrodes (7, 8) for the n-channel or p-channel transistor are already defined,
b) deposition of a silicon-nitride layer (10) on the first SiO₂ layer (9),
c) carrying out a photoresist technique (11) and structuring of the double layer comprising the SiO₂ layer (9) and the silicon-nitride layer (10), such that the later p-channel region (2) remains covered by the double layer,
d) carrying out a thermal oxidation (13) of the gate electrode (7) of the n-channel transistor after removal of the photoresist mask (11),
e) carrying out a connection implantation (12) for the n-channel transistor,
f) deposition of a second SiO₂ layer (14) and anisotropic back-etching of this layer such that oxide regions (14) remain on the edges of the n-channel transistor gate electrode (7),
g) carrying out the source/drain ion implantation (15) for producing the n-channel transistor and driving in the implanted doping materials,
h) applying a photoresist mask (16) onto the n-channel region which is not covered by the double layer, and removing the remaining second SiO₂ layer (14a) by isotropic etching over at stages in the p-channel region which are produced by the double layer,
i) removal of the silicon-nitride layer (10),
j) carrying out the source/drain ion implantation (18) in order to produce the p-channel transistor, and removal of the photoresist mask (16), and
k) production of the intermediate-insulation oxide, of the contact hole regions and of the metallisation in a known manner,
l) the thickness of the first SiO₂ layer (9), the implantation energy of the source/drain implantation (18) according to method step j) and subsequent high-temperature processes being set such that the source/drain doping (18) just extends under the gate electrode of the p-channel transistor.

## Revendications

1. Procédé pour fabriquer des transistors MOS à effet de champ complémentaires en technique VLSI, selon lequel, pour loger un transistor à canal n ou p du circuit, on forme, dans le substrat en silicium, des cuvettes dopées de type p ou n, dans lesquelles, pour régler les différents tensions de déclenchement des transistors, on introduit les atomes correspondants de substance dopante au moyen d'une implantation ionique multiple, et selon lequel le masquage pour les différentes implantations ioniques s'effectue au moyen de structures de laque photosensible et/ou d'oxyde de silicium ou de nitrure de silicium, et selon lequel, en outre, pour réduire la diffusion des régions implantées de source/drain au-dessous de la surface de grille, on pourvoit des électrodes de grille d'un oxyde de flanc, et selon lequel la fabrication des régions de source/drain et grille ainsi que la production d'un oxyde intermédiaire et d'un oxyde isolant et de plans métalliques de contact est exécutée selon des étapes opératoires connues de la technologie MOS,
caractérisé par l'exécution d'étapes opératoires suivantes :
a) dépôt d'une première couche de SiO₂ (9), avec une épaisseur de couche, qui correspond à la largeur (17,19) de l'oxyde de flanc de la grille (8) du transistor à canal p devant être formé ultérieurement, sur un substrat en silicium (1) dopé du type p ou n et dans lequel, selon des étapes opératoires connues, des cuvettes de type n ou p (2), des zones d'oxyde de champ (3) séparant des zones actives du transistor, ainsi que des implantations de canal (4,5) pour le transistor à canal n et le transistor à canal p et un oxyde de grille (6) et les électrodes de grille (7,8) pour le transistor à canal n ou le transistor à canal p, sont déjà définies,
b) dépôt d'une couche de nitrure de silicium (10) sur la première couche de SiO₂,
c) mise en oeuvre d'une technique utilisant une photolaque (11) et structuration de la couche double constituée par la couche de SiO₂ (9) et la couche de nitrure de silicium (10) de manière que la région de canal p (2) formée ultérieurement reste recouverte par la couche double,
d) exécution d'une oxydation thermique (13) de l'électrode de grille (7) du transistor à canal n, après élimination du masque de photolaque (11),
e) exécution d'une implantation ultérieure (12) pour le transistor à canal n,
f) dépôt d'une seconde couche de SiO₂ (14) et rétrocorrosion anisotrope de cette couche de manière que des zones d'oxyde (14) subsistent sur les flancs de l'électrode de grille (7) du transistor à canal n,
g) exécution de l'implantation ionique de source/drain (15) pour former le transistor à canal n et faire pénétrer les substances dopantes implantées,
h) dépôt d'un masque de photolaque (16) sur la région de canal de type n non recouverte par la couche double, et élimination de la seconde couche restante de SiO₂ (14a) au niveau des parties étagées, produites par la couche double, dans la région du canal de type p, par corrosion isotrope excessive,
i) élimination de la couche de nitrure de silicium (10),
j) rétrocorrosion anisotrope de la première couche de SiO₂ (9) de manière que des régions d'oxyde (17) subsistent sur les flancs de l'électrode de grille (8) dans la région (2) de canal de type p et qu'un oxyde résiduel possédant une épaisseur de couche d'environ 50 nm ou moins subsiste sur la région active du transistor à canal p,
k) exécution de l'implantation ionique de source/drain (18) pour former le transistor à canal p, et élimination du masque de photolaque (16), et
l) production de l'oxyde isolant intercalaire, des régions des trous de contact et de la métallisation, d'une manière connue.

2. Procédé suivant la revendication 1, caractérisé par le fait qu'on fabrique la première couche de SiO₂ (9), selon l'étape opératoire (a), par dépôt à partir de la phase gazeuse (CVD = Chemical Vapor Deposition) et on règle son épaisseur de couche à une valeur supérieure à 100 nm.

3. Procédé suivant la revendication 1 et/ou 2, caractérisé par le fait qu'on fabrique la couche de nitrure de silicium (10) selon l'étape opératoire b) par dépôt à partir de la phase gazeuse (CVD) et qu'on règle son épaisseur de couche dans la gamme de 50 à 100 nm.

4. Procédé suivant l'une des revendications 1 à 3, caractérisé par le fait qu'on fabrique la seconde couche de SiO₂ (14) selon l'étape opératoire f) par dépôt à partir de la phase gazeuse (CVD) et qu'on règle son épaisseur de couche entre 150 et 300 nm.

5. Procédé suivant l'une des revendications 1 à 4, caractérisé par le fait qu'on exécute l'oxydation thermique selon l'étape opératoire d) de manière à obtenir une couche de SiO₂ (13) possédant une épaisseur de 30 à 50 nm.

6. Procédé suivant l'une des revendications 1 à 5, caractérisé par le fait qu'on exécute l'implantation ultérieure (12) pour le transistor à canal n selon l'étape opératoire e) en utilisant des ions de phosphore avec une dose comprise entre 5 x 10¹² et 1 x 10¹³ cm⁻² et une énergie de 80 keV.

7. Procédé suivant l'une des revendications 1 à 6, caractérisé par le fait qu'on exécute l'implantation de source/drain (15) du transistor à canal n selon l'étape opératoire g) avec des ions d'arsenic et en utilisant une dose comprise entre 3 x 10¹⁵ et 8 x 10¹⁵ cm⁻² et une énergie égale à 80 keV.

8. Procédé suivant la revendication 7, caractérisé par le fait qu'avant l'implantation (15), on dépose un oxyde de dispersion avec une épaisseur de couche située dans la gamme de 30 à 50 nm.

9. Procédé suivant l'une des revendications 1 à 8, caractérisé par le fait qu'on règle l'épaisseur de l'oxyde résiduel selon l'étape j) à environ 50 nm.

10. Procédé suivant l'une des revendications 1 à 9, caractérisé par le fait qu'on exécute l'implantation de source/drain (18) du transistor à canal n et à canal p en utilisant des ions de bore en une dose égale à 5 x 10¹⁵ cm⁻² et une énergie égale à 25 keV.

11. Procédé pour fabriquer des transistors MOS à effet de champ complémentaires en technique VLSI, selon lequel, pour loger un transistor à canal n ou p du circuit, on forme, dans le substrat en silicium, des cuvettes dopées de type p ou n, dans lesquelles, pour régler les différents tensions de déclenchement des transistors, on introduit les atomes correspondants de substance dopante au moyen d'une implantation ionique multiple, et selon lequel le masquage pour les différentes implantations ioniques s'effectue au moyen de structures de laque photosensible et/ou d'oxyde de silicium ou de nitrure de silicium, et selon lequel, en outre, pour réduire la diffusion des régions implantées de source/drain au-dessous de la surface de grille, on pourvoit des électrodes de grille d'un oxyde de flanc, et selon lequel la fabrication des régions de source/drain et grille ainsi que la production d'un oxyde intermédiaire et d'un oxyde isolant et de plans métalliques de contact est exécutée selon des étapes opératoires connues de la technologie MOS,
caractérisé par l'exécution d'étapes opératoires suivantes :
a) dépôt d'une première couche de SiO₂ (9) avec une épaisseur de couche qui correspond à la largeur (17,19) de l'oxyde de flanc de la grille (8) du transistor à canal p devant être formé ultérieurement, sur un substrat en silicium (1) dopé du type p ou n et dans lequel, selon des étapes opératoires connues, des cuvettes de type n ou p (2), des zones d'oxyde de champ (3) séparant des zones actives du transistor, ainsi que des implantations de canal (4,5) pour le transistor à canal n et le transistor à canal p et un oxyde de grille (6) et les électrodes de grille (7,8) pour le transistor à canal n ou le transistor à canal p sont déjà définies,
b) mise en oeuvre d'une technique utilisant une photolaque (11) et structuration de la couche de SiO₂ (9) de manière que la région de canal de type p (2) formée ultérieurement reste recouverte par la couche de SiO₂ (9),
c) exécution d'une oxydation thermique (13) de l'électrode de grille (7) du transistor à canal n, après élimination du masque de photolaque (11),
d) exécution d'une implantation ultérieure (12) pour le transistor à canal n,
e) dépôt d'une couche de polysilicium non dopé possédant une épaisseur de 0,2 à 0,4 µm,
f) exécution de l'implantation ionique de source/drain (15) pour former le transistor à canal n et faire pénétrer les substances dopantes implantées,
g) dépôt d'un masque de photolaque (16) sur la région de canal de type n non recouverte par la couche de SiO₂ (9),
h) rétrocorrosion anisotrope de la première couche de SiO₂ (9) de manière que des régions d'oxyde (17) subsistent sur les flancs de l'électrode de grille (8) dans la région de canal de type p (2) et d'un oxyde résiduel possédant une épaisseur de couche d'environ 50 nm ou moins subsiste sur la région active du transistor à canal p,
i) exécution de l'implantation ionique de source/drain (18) pour former le transistor à canal p et élimination du masque de photolaque (16), et
j) production de l'oxyde d'isolant intercalaire, des régions des trous de contact et de la métallisation, d'une manière connue.

12. Procédé suivant l'une des revendications 1 à 11, caractérisé par le fait qu'avant le dépôt de la première couche de SiO₂ (9) selon l'étape opératoire a), on exécute une implantation d'ions de bore (20,21) sur toute la surface avec une dose égale à 10¹² cm⁻² et une énergie comprise entre 25 et 50 keV.

13. Procédé pour fabriquer des transistors MOS à effet de champ complémentaires en technique VLSI, selon lequel, pour loger un transistor à canal n ou p du circuit, on forme, dans le substrat en silicium, des cuvettes dopées de type p ou n, dans lesquelles, pour régler les différents tensions de déclenchement des transistors, on introduit les atomes correspondants de substance dopante au moyen d'une implantation ionique multiple, et selon lequel le masquage pour les différentes implantations ioniques s'effectue au moyen de structures de laque photosensible et/ou d'oxyde de silicium ou de nitrure de silicium, et selon lequel, en outre, pour réduire la diffusion des régions implantées de source/drain au-dessous de la surface de grille, on pourvoit des électrodes de grille d'un oxyde de flanc, et selon lequel la fabrication des régions de source/drain et grille ainsi que la production d'un oxyde intermédiaire et d'un oxyde isolant et de plans métalliques de contact, est exécutée selon des étapes opératoires connues de la technologie MOS,
caractérisé par l'exécution d'étapes opératoires suivantes :
a) dépôt d'une première couche de SiO₂ (9) avec une épaisseur de couche, qui correspond à la largeur (17,19) de l'oxyde de flanc de la grille (8) du transistor à canal p devant être formé ultérieurement, sur un substrat en silicium (1) dopé du type p ou n et dans lequel, selon des étapes opératoires connues, des cuvettes de type n ou p (2), des zones d'oxyde de champ (3) séparant des zones actives du transistor, ainsi que des implantations de canal (4,5) pour le transistor à canal n et le transistor à canal p et un oxyde de grille (6) et les électrodes de grille (7,8) pour le transistor à canal n ou le transistor à canal p, sont déjà définies,
b) dépôt d'une couche de nitrure de silicium (10) sur la première couche de SiO₂,
c) mise en oeuvre d'une technique (11) utilisant une laque photosensible et structuration de la couche double constituée par la couche de SiO₂ (9) et par la couche de nitrure de silicium (10), de manière que la région de canal de type p (2) formée ultérieurement reste recouverte par la couche double,
d) exécution d'une oxydation thermique (13) de l'électrode de grille (7) du transistor à canal n, après élimination du masque de photolaque (11),
e) exécution d'une implantation ultérieure (12) pour le transistor à canal n,
f) dépôt d'une seconde couche de SiO₂ (14) et rétrocorrosion anisotrope de cette couche de manière que des zones d'oxyde (14) subsistent sur les flancs de l'électrode de grille (7) du transistor à canal n,
g) exécution de l'implantation ionique de source/drain (15) pour former le transistor à canal n et faire pénétrer les substances dopantes implantées,
h) dépôt d'un masque de photolaque (16) sur la région de canal de type n non recouverte par la couche double, et élimination de la seconde couche restante de SiO₂ (14a) au niveau des parties étagées, produites par la couche double, dans la région du canal de type p, par corrosion isotrope excessive,
i) élimination de la couche de nitrure de silicium (10),
j) exécution de l'implantation ionique de source/drain (18) pour former le transistor à canal p et éliminer le masque de photolaque (16),
k) production de l'oxyde isolant intercalaire, des régions des trous de contact et de la métallisation, de façon connue,
l) l'épaisseur de la première couche de SiO₂, l'énergie d'implantation de la source/du drain (18) selon l'étape opératoire j) et les processus suivants de traitement à haute température sont réglés de manière que le dopage de la source/du drain (18) s'étende précisément au-dessous de l'électrode de grille du transistor à canal p.
